# EUROPEAN PATENT APPLICATION

(11) **EP 0 536 834 A2**
(43) Date of publication of application: **14.04.1993**
(21) Application number: 92203004.4
(22) Date of filing: 30.09.1992
(51) Int. Cl.: H01L 29/796, G11C 19/28

(54) **Charge-coupled device**

(30) Priority: 10.10.1991 EP 91202636
(71) Applicant: Philips Electronics N.V., 5621 BA Eindhoven (NL)
(72) Inventor: Sankaranarayanan, Lakshmi Narayanan c/o, NL-5656 AA Eindhoven (NL)
(74) Representative: Houbiers, Ernest Emile Marie Gerlach

(57) **Abstract**

The invention relates to a charge-coupled device which has two or more parallel channels provided with a demultiplexer by which a series of consecutive signals is distributed over the parallel channels. For each signal, a given number of charge packages is formed, corresponding in size to the input signal, of which only one is stored in the relevant channel while the remaining charge packages are drained off. This method of demultiplexing imposes no or at leat substantially no speed limitations on the device, which as a result is particularly suitable as a memory or delay line for very high frequency signals, for example, of 1 GHz. In a particular embodiment, the charge-coupled device is of the buried channel type with an npn (or pnp) structure in which the charge packages are drained off through the substrate.

## Description

The invention relates to a charge-coupled device comprising a semiconductor body at a surface of which at least two adjacent charge transport channels or portions thereof are defined for demultiplexed storage and/or transport of signals which are supplied serially through a input.

Such a device may be used, for example, as a delay line and/or memory for a high-frequency signal. If a single serial register were used for such a purpose, high-frequency clock voltages would be required for its operation, so that the dissipation will also be high. To obtain the desired memory capacity, the length of the serial register can become fairly great, as a result of which each signal must be transported through a large number of steps. This can lead to a comparatively great distortion of the stored signal, in particular with high frequencies. It is possible to work with shorter channels, which in addition can be operated at a lower speed, in that the information is stored demultiplexed in parallel channels.

A known device of this type is the SPS memory which comprises a serial input register, a parallel section forming the memory matrix, and a serial output register. The information is read at high speed into the input register and, when this is full, transferred to the parallel section. The transport of the charge packages from the serial register to the parallel channels usually is comparatively slow as a result of the required electrode configuration. The clocks of the serial register must be stopped abruptly during the serial-parallel transport, which may lead to design problems.

Another device of the type to which the invention relates and which is known *per se* is described, for example, in "Charge-Coupled Devices" by Howes & Morgan, John Wiley & Sons, reprinted June 1980, pp. 120-121. Here n parallel, n-phase channels having a common input are used, which are so operated that the k^{th} channel samples the input signal in the k^{th} phase. This also leads to problems with very high frequencies because of the stringent requirements imposed on the steepness of the clock edges.
A demultiplex device of the kind described above may also be used for purposes other than memories such as, for example, analog signal processing.

The invention has for its object *inter alia* to provide a demultiplex delay line which is suitable for very high frequency signals. The invention has for its further object *inter alia* to provide a demultiplex device, whether or not in conjunction with the purpose formulated above, which device can be operated with simple clock signals.

The invention is based *inter alia* on the recognition that a charge package in a charge-coupled channel can be discharged easily and, if so desired, at very high speed to discharging means situated outside the channel.
According to the invention, a charge-coupled device of the kind mentioned in the opening paragraph is characterized in that a charge package corresponding to the supplied input signal is supplied to each of the said charge transport channels, and each of the said charge transport channels or portions thereof is provided with discharging means by which charge packages corresponding to supplied signals other than the signals destined for each of the charge transport channels are drained. Since each input signal is supplied to the (each) channel of the demultiplexer, conventional clock signals can suffice at the input. The discharge of the excess charge can be effected quickly and by techniques known *per se* in imaging devices, as will become apparent from the description of the Figures.

For draining excess charge packages, techniques may be used which are used in image sensors for draining charge generated during overexposure (anti-blooming), whereby a drain is formed next to the picture elements which is separated from the charge storage locations in which the charge is integrated by a potential barrier of an accurately chosen level. When the storage location is completely filled with charge owing to overexposure, the remainder of the generated charge will flow into the drain through the barrier. In a device according to the invention, a charge package may be drained through the use of a similar configuration in that the potential of the storage location in which the package is stored is changed, so that the charge flows to the drain, the barrier being removed simply by lowering the voltage at the relevant clock electrode (in the case of an n-channel CCD) or by raising it (in the case of a p-channel CCD).

The discharging means may lie next to the charge transport channel, seen at the surface. A special embodiment, which has the advantage of a compact configuration since the discharging means do not require additional semiconductor surface area, is characterized in that the charge transport channels or portions thereof are of the buried channel type and comprise a layer of a first conductivity type which is situated at or near the surface and which is separated from a region of the first conductivity type, which forms a drain for the said charge packages to be discharged, by a subjacent layer of the second, opposite conductivity type under which the said region of the first conductivity type is situated.

A further embodiment of a device according to the invention, which has the advantage *inter alia* that the charge can be very quickly drained under the influence of electric fields is characterized in that the layer of the second conductivity type has a thickness and a doping concentration at which the layer can be depleted throughout its entire thickness during operation without breakdown.

The invention will be explained in more detail with reference to a few embodiments and the accompanying diagrammatic drawing in which:
Fig. 1 is a diagrammatic plan view of a portion of a charge-coupled device according to the invention;
Fig. 2 is a cross-section of the device of Fig. 1 taken on the line II-II;
Fig. 3 is a cross-section of the same device taken on the line III-III;
Fig. 4 is a potential diagram in a direction transverse to the surface;
Fig. 5 is a diagram of clock voltages applied to the device according to Fig. 1 during operation;
Fig. 6 diagrammatically depicts the demultiplexing method in this device;
Fig. 7 diagrammatically shows a second embodiment of a charge-coupled device according to the invention in plan view; and
Fig. 8 is a diagram of clock voltages applied to the electrodes of this device during operation.

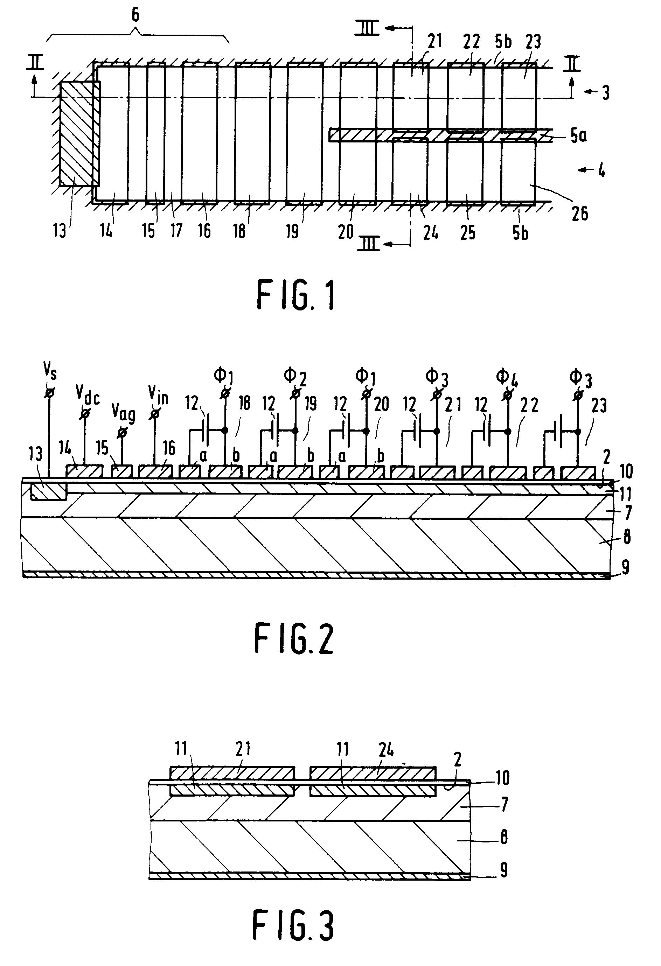

It is noted that the Figures are diagrammatic and not drawn to scale. The principle of the invention will first be described with reference to a simple embodiment according to Figs. 1-3. The device comprises a semiconductor body 1 which in the present example is made of silicon, but which obviously may alternatively be made from another suitable semiconductor material. At the surface 2 of the semiconductor body 1 there are two adjacent charge transport channels 3 and 4 for demultiplexed storage and transport of signals which are supplied successively in the time domain, for example, through a external signal source Vᵢₙ. "Demultiplexed" here denotes the mode of operation in which the signals are introduced alternatively into the one channel and into the other channel, for example, the signals having a even serial number into channel 3 and the signals having a odd serial number into channel 4. This mode of operation has the advantage *inter alia* that at a given high sampling frequency, which determines the maximum frequency in the input signal, the channels 3, 4 can be operated at a clock frequency which is only half the frequency which would obtain in a single channel.

The channels 3 and 4 are mutually separated by a channel splitter 5a which is shown hatched in Fig. 1, as is the lateral channel limiter 5b. The device comprises an input stage 6 through which a charge package corresponding to an input signal can be supplied to each of the charge transport channels 3 and 4. Each of the charge transport channels 3 and 4 is provided with discharging means 7, 8 and 9 by means of which charge packages corresponding to signals other than those destined for each of the channels 3 and 4 can be drained off. In the case referred to above, in which signals having an even serial number are stored in channel 3, signal charges corresponding to signals having odd serial numbers are discharged through the discharging means in channel 3. Since the speed at which the charge is drained can be very high, the input frequency is not or at least substantially not influenced by the demultiplexing action.

Advatageously, a charge-coupled device with surface transport in which the charge carriers are stored and displaced at the interface between the silicon body 1 and a silicon oxide layer 10 covering the surface 2, can be used. Because of the better frequency characteristics, a charge-coupled device of the buried channel type which is known *per se* was chosen for the present embodiment. The buried channel is formed by a comparatively shallow surface layer 11 of one conductivity type, for example of the n-type in the case of an n-channel device, which adjoins a region 7 of the other conductivity type, in this example the p-type, at the side opposite to the surface. This region at its lower side adjoins a region 8 of the first, so n-conductivity type. During operation, a sufficient positive voltage is applied to the region 8 through connection 9 for charge packages which must not be transported any further to be drained through the region 8.

For a good drainage of the charge carriers, the p-type region 7 may be locally provided with openings below the channels 11 through which the n-type region 8 is connected to the n-type channels 11 and in which the potential is set by the voltage at the region 7 through field effect action. In the present embodiment, the region 7 forms a continuous layer of the second, so p-type with such a thickness and doping concentration that a depletion region can be formed throughout the entire layer thickness while breakdown is avoided. The potential in the p-type region 7 may be set for a suitable value in a simple manner so that, if so desired, electrons can be discharged quickly and efficiently, more or less analogous to the manner in which excess charge is drained off in the case of overexposure in CCD imaging devices (anti-blooming).

The charge-coupled devices 3 and 4 are 2-phase devices, as is visible in Fig. 2, with clock electrodes comprising a transfer gate a and a storage gate b, while means 12 are present for obtaining a potential hill below the parts a and a potential well below the parts b. In the drawing, the parts a and b are connected to one another through a voltage source 12, so that the clock voltages to be applied to the parts a are always lower than those for the parts b. It will be clear, however, that other methods known *per se* for incorporating a transport direction, such as variation of the oxide thickness or charge in or below the oxide 10, may alternatively be used. It is also possible to apply separate clock voltages to the electrode parts a and b with mutually equal phases and mutually shifted voltage values.

The signal source Vᵢₙ is connected to the input stage 6 through the input gate 16, which stage comprises in addition to the n-type input zone 13 the gates 14, 15 and 16 and the channel 17 situated below these gates and forming a common supply channel for the channels 3 and 4. As will be explained below in the description of the operation of the device, the input stage 6 is operated at a frequency which is twice the frequency of the parallel charge transport channels 3 and 4. The input stage 6 is a modified version of the sampling method known in the literature under the designation "fill & spill", which version is described *inter alia* in British Patent Application 9011507.2 by Applicant.

The input gate 16 is formed by three gates 18, 19, 20 which together with the channel 17 form a 2-phase CCD and is controlled by the high-frequency clock voltages φ₁ and φ₂. At the area of the electrode 20, the charge packages are divided into two halves by the channel splitter 5, which halves are transported further either by the channel 3 or by the channel 4. The drawing shows only three electrodes, electrodes 21, 22, 23, belonging to channel 3 and the electrodes 24, 25, 26 belonging to channel 4. The gates 21-26 are controlled by 2-phase clocks φ₃ and φ₄, in such a way that a clock voltage is applied to each of the gates 21-23 of channel 3 which has a phase opposite to that of the clock voltage applied to the adjacent gate in channel 4. When φ₃ is applied to gate 21, for example, the clock voltage φ₄ is applied to the adjacent gate 24 in the other channel.

The n-type region 8 is formed by a silicon substrate with a doping level of 5.10¹⁴ - 10¹⁵ atoms per cm³. The substrate thickness is, for example, approximately 300 µm. To improve the contact 9, a highly doped zone may be provided at the lower side. The p-type surface zone 7 has a thickness of approximately 3,6 µm and a doping concentration of approximately 10¹⁵ atoms per cm³. The n-type surface zones, which form the buried channels 11 and 17, have a thickness of approximately 0,8 µm and a doping of 10¹⁶ atoms per cm³. The thickness of the oxide layer 10 is approximately 0,1 µm. The gate electrodes provided on the oxide layer 10 are represented in the drawing as conductors situated next to one another for the sake of simplicity. In actual fact, the electrodes may be constructed in known manner as mutually overlapping gates of, for example, polycrystalline silicon.

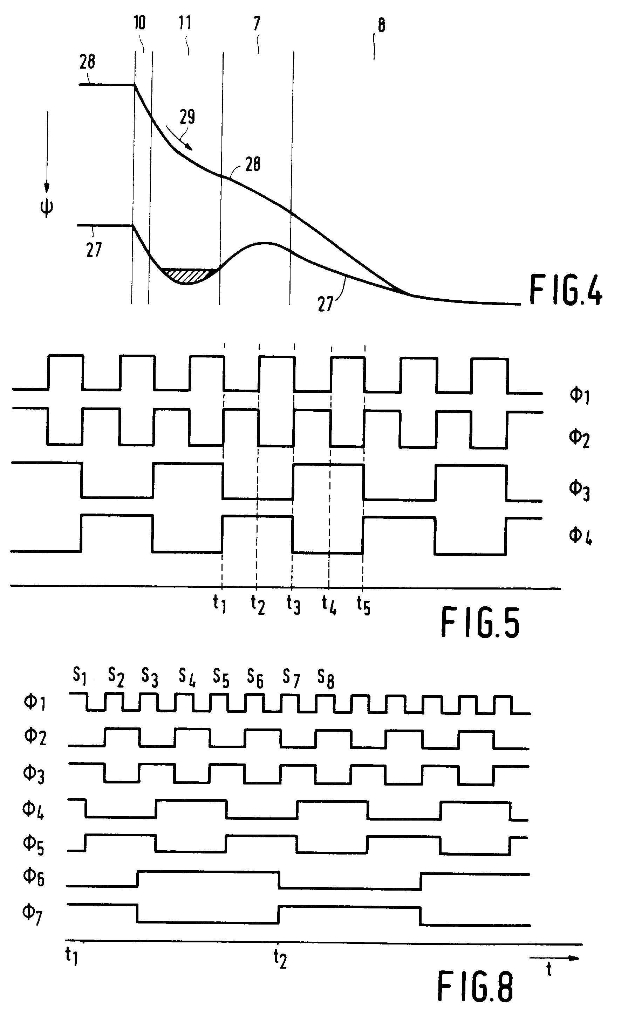

It will first be described with reference to Fig. 4 how charge packages are drained through the substrate 8 in the configuration shown. In the drawing, the potential ψ in the semiconductor body is plotted in downward direction as a function of the distance transverse to the surface. The vertical lines in the drawing represent the interfaces between the various regions. The horizontal lines to the left in the Figure represent two different voltages which may be applied to the gates. A positive voltage of, for example, xx volts is applied to the substrate 8 through the contact 9. If the layers 9 and 11 are fully depleted, the potential profile according to the line 27 is obtained in the semiconductor body at a gate voltage of, for example, 4 volts. A potential well is formed in the n-type layer 11 in which a charge package, represented by the hatched region, can be stored. This charge cannot flow to the substrate through the barrier in the p-type layer 7. When the low voltage level is applied, for example -4 volts, the potential profile below the relevant gate becomes as indicated by the curve 28. If adjacent gates are also at the low voltage level, so that the charge cannot be further transported through the channel 11, the entire charge package stored below this gate is drained off to the substrate 8. This is diagrammatically shown in Fig. 4 by arrow 29. It should be noted in this connection that the presence of an electrical drift field causes this vertical charge transport to take place very quickly, so that no or substantially no speed limitations are imposed on the device thereby.

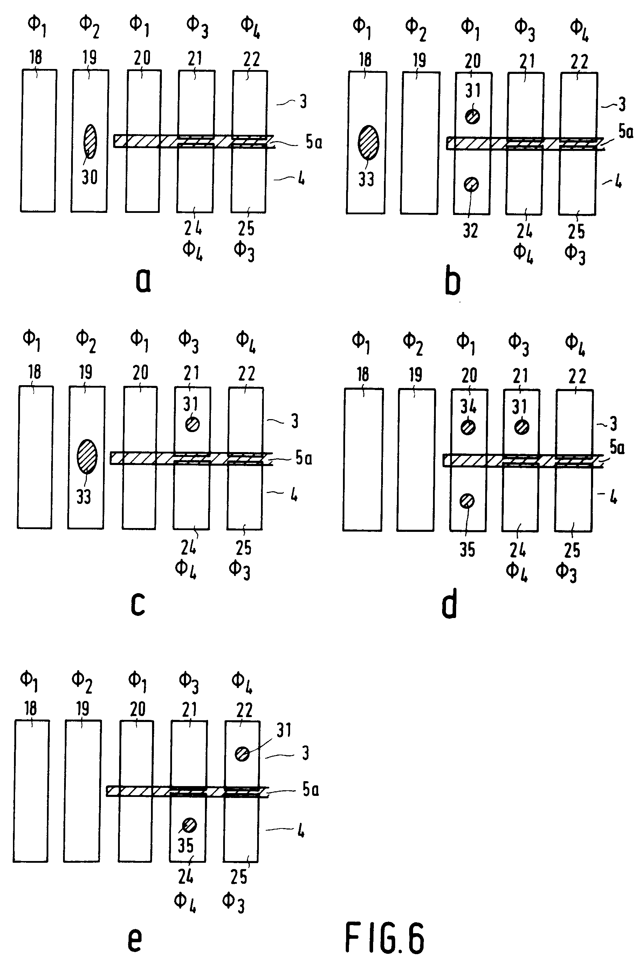

The principle described here, *i.e*. of charge being drained from the channel below a gate if the gate following the charge storage location of the charge package remains at the blocking voltage level, is used in combination with the vertical draining mechanism described above for the operation of the demultiplex device according to the invention to be described below. Fig. 5 shows the clock voltages φ₁ and φ₂ applied to the gates 18, 19 and 20, and the clock voltages φ₃ and φ₄ applied to the gates 21-26. As the drawing shows, the channels 3 and 4 are operated at half the clock frequency of the input channel 17. To clarify the operation, Fig. 6 diagrammatically shows a portion of the input channel 17 and the adjoining portions of the channels 3 and 4 with the associated gates at four moments during operation. In addition, the clock voltages applied to the various gates are indicated in the drawings. It is noted that the clock voltages at the gates 21 and 24 are in opposite phases. Fig. 6a shows the situation at moment t₁. A charge package 30, symbolized by the hatched region below gate 19, is stored below the gate 19. At t₂, φ₂ becomes low while φ₁ becomes high. The charge package 30 is transported to gate 20, where it is divided over the channels 3 and 4 in at least substantially equal portions 31 and 32 by the channel splitter 5. A next charge package 33 is simultaneously stored below the gate 18, see Fig. 6b. At t₃, φ₁ becomes low and φ₃ becomes high. The charge package 31 can flow on to the storage location below gate 21 in channel 3, see Fig. 6c. Since φ₄ becomes low at t₃, the charge package 32 cannot flow further to the charge storage location below gate 24. Since also transport to the left, to gate 19, is prevented by the potential barrier built in for the 2-phase operation, the discharging mechanism described with reference to Fig. 4 becomes operational, so that the package or sub-package 32 is drained off through the substrate 8. Meanwhile, the charge package 33 corresponding to a next signal shifts from gate 18 to gate 19 and subsequently, at t₄, to gate 20, where it is divided into two equal or at least substantially equal portions 34 and 35, see Fig. 6d. At t₅, φ₃ and φ₄ become low and high, respectively, so that the package 31 is transported to gate 22, see Fig. 6e. Since φ₄ is high, the package 35 is also transported in channel 4 to gate 24. Owing to the low voltage φ₃, the charge package 34 in channel 3 cannot be transported any further and is accordingly drained off through the substrate 8 at the low voltage φ₁. The next signal is again stored in channel 3 and the one after that in channel 4. Through a cyclic repetition of the process described here, signals can thus be stored alternately in the sub-channels 3 and 4 and be transported further at a clock frequency which is only half the frequency of the clocks φ₁ and φ₂.

The demultiplexing method described here may be repeated in that the channels 3 and 4 are each split up into two sub-channels which are operated at half the clock frequency of the channels 3 and 4.

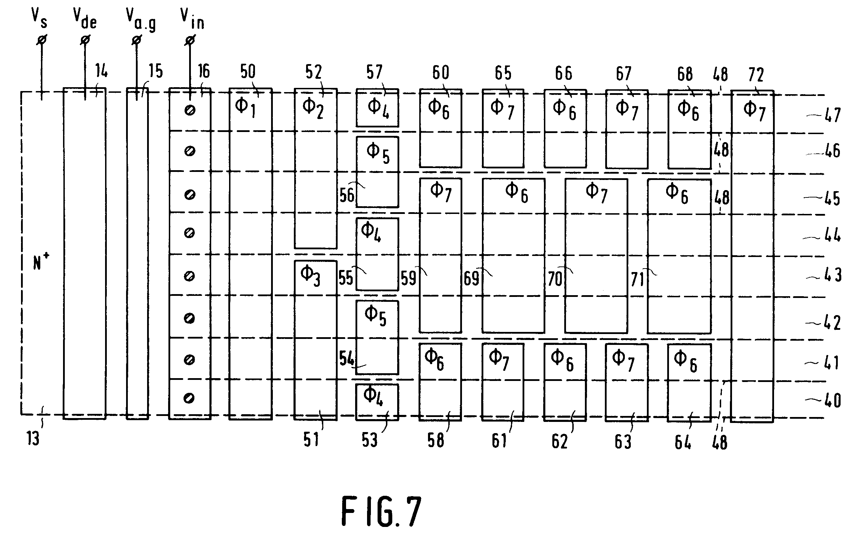

Fig. 7 gives a diagrammatic plan view of a device according to the invention with an 8-fold demultiplexer in which each input signal is not split up once or several times as in the preceding embodiment, but is supplied to the input in the form of eight charge packages of which only one is allowed to pass each time and the remaining seven charge packages are drained off. The device comprises an input stage which is practically identical to the input in the preceding embodiment, with an input zone 13, an adjacent gate 14 with a V_{dc} connection, a sampling gate 15, and the input gate 16 which is provided with a connection for the supply of the input signal Vᵢₙ. The eight parallel channels 40-47 are defined by channel limiting zones 48 which are shown only diagrammatically in the drawing each by a single broken line. As is evident from Fig. 7, the channel limiting zones 48 separating the channels 40-47 from one another extend to below the input gate 16, so that a charge package corresponding to the input signal Vᵢₙ is formed below the gate 16 in each of the channels 40-47. The gate electrodes following the input gate, shown only diagrammatically as rectangles for the sake of simplicity, are assumed to comprise a transfer part and a storage part corresponding to the parts a and b of the electrodes 18-26 in the preceding embodiment. The applied clock voltages φᵢ are also indicated in these gates for the sake of clarity. The clocks φ are drawn as a function of time in Fig. 8. The input gate 16 is followed by the gate 50 which extends over the eight channels 40-47. The clock voltage φ₁, which has a frequency of, for example, 1 GHz, is applied to the gate 50. The gate 50 is followed by two gates 51 and 52, of which the gate 51 is situated over the channels 40-43 and the gate 52 over the channels 44-47. Clock voltages φ₃ and φ₄ are applied to the gates 51 and 52, respectively, which are in opposite phases, as is shown in Fig. 8. The clock frequency of φ₂ and φ₃ is half the frequency of φ₁, so 500 MHz. At the next storage location, the associated clock electrode is divided into four gates, 53-57, of which gate 53 is situated over channel 40, gate 54 over channels 41 and 42, gate 55 over channels 43 and 44, gate 56 over channels 45 and 46, and gate 57 over channel 47. The clock voltage φ₄ is applied to the gates 54, 55 and 57, and the clock voltage φ₅ to the gates 54 and 56. These voltages, as can be seen in Fig. 8, are again in opposite phases and have a clock frequency which is half that of φ₂ and φ₃, so a frequency of only 250 MHz. After this there are three gates 58, 59 and 60 to which the respective clock voltages φ₆, φ₇ and φ₆ are applied. The clock voltages φ_{6/7} are in opposite phase and have a frequency of only 125 MHz. The next gates are also controlled by the clocks φ_{6/7}. Since the charge packages in the eight channels are no longer in one line during operation after demultiplexing, the gates 58 and 60 over the channels 40, 41 and 46, 47 are followed by four relatively narrow gates 61-64 and 65-68 as opposed to only three relatively wide gates 69-71 which follow the gate 59 over the channels 43-45. Since the charge packages which are stored or transported in the channels 40, 41 and 46, 47 must travel over one storage location more than the charge packages in the channels 43, 44 and 45, the eight charge packages at the gates 64, 71 and 68 are again stored in one line. The next gate, gate 72, controlled with the clock voltage φ₇, again forms a common gate for the eight channels 40-47. The gate 72 is followed by a row of gates, not shown in the drawing, which are common to the eight channels 40-47 and which are alternately controlled with the clock voltages φ₆ and φ₇. The number of gates is determined by the required memory capacity and/or the desired delay time.

During operation eight equal charge packages, represented in the drawing by black dots, are formed below the input gate 16, their values being determined by the input signal Vᵢₙ. Fig. 8 shows eight consecutive input signals identified with S₁, S₂, S₃, ..., S₈. The eight charge packages corresponding to S₁ are transported below gate 50 when φ₁ is high. φ₁ becomes high at T1, so that they must accordingly be removed below this gate. The charge packages in channels 40-43 can be stored below gate 51 since φ₃ is high. The charge packages at S₁ in channels 44-48 cannot be stored below gate 52 since φ₂ is low at t₁. These charge packages, accordingly, are drained off to and through the substrate in the manner described above. It can be easily ascertained from the clock diagram of Fig. 8 that, when φ₃ becomes low, of the charge packages below gate 51 the charge packages in the channels 41 and 42 are transported to gate 54 (φ₅ high) whereas the charge packages in the channels 40 and 43 are drained off to the substrate (φ₄ low). Of the two charge packages stored below gate 54, the charge package in channel 4 is transported further to gate 58 (φ₆ high); the charge package below gate 54 in channel 42 on the other hand is drained off to the substrate. Of the eight charge packages formed below gate 16 and corresponding to input signal S₁ only one charge package has remained, stored below gate 58 in channel 41. In an analogous manner, charge packages (corresponding to) S₂ below gate 60 in channel 46, S₃ below gate 58 in channel 40, S₄ below gate 60 in channel 47, S₅-S₈ below gate 59 in channels 42, 45, 43, 44, respectively, are processed.

It is noted that, whereas the signals S₅, S₆, S₇ and S₈ are stored below gate 59, the charge packages S₁, S₂, S₃ and S₄ have been displaced to the gates 61 and 65 at t₂ and are accordingly one gate further than the charge packages below the gate 59. This difference is eliminated in that the lengths of the gates 69, 70 and 71 above the channels 42-55 are chosen to be slightly greater than the lengths of the gates 61-68 above the other channels. In the embodiment drawn here, the distance covered in three transport steps in the channels 42-45 corresponds to the distance covered by four transport steps in the channels 40, 41, 46 and 47. Starting from the gates 64, 71 and 68, which may also be constructed as an integral unit, the charge packages S₁, S₂, S₃, ..., S₈ can be transported further in parallel fashion.

The readout may take place in known manner, for example, by means of a serial output register in which the signals S₁, S₂, S₃, ..., S₈ are put in in parallel and are read out serially. It is also possible for the channels 40-47 to be provided with an output where the signals are read. This output may be a common one when the channels 40-47 have different lengths as a result of which the signals S₁, ..., S₈ arrive at the output at different moments. The lengths of the channels may then be so chosen that first S₁ is read out, then S₂, followed by S₃, etc.

It will be obvious that the invention is not limited to the embodiments described above, but that many variations are possible to those skilled in the art within the scope of the invention. Thus, instead of the vertical discharging mechanism described here (which may also be advantageously used in signal processing devices other than the demultiplexers described here), a lateral drainage corresponding to the drainage in imaging devices with lateral anti-blooming may be used. In the second embodiment, the portion behind the demultiplexer may alternatively be a 3-phase or a 4-phase CCD instead of a 2-phase device. The invention, furthermore, can also be used in charge-coupled devices with charge transport along the surface.

## Claims

1. A charge-coupled device comprising a semiconductor body at a surface of which at least two adjacent charge transport channels or portions thereof are defined for demultiplexed storage and/or transport of signals which are supplied serially through an input, characterized in that a charge package corresponding to the supplied input signal is supplied to each of the said charge transport channels, and each of the said charge transport channels or portions thereof is provided with discharging means by which charge packages corresponding to supplied signals other than the signals destined for each of the charge transport channels are drained.

2. A charge-coupled device as claimed in Claim 1, characterized in that the charge transport channels or portions thereof are of the buried channel type and comprise a layer of a first conductivity type which is situated at or near the surface and which is separated from a region of the first conductivity type, which forms a drain for the said charge packages to be discharged, by a subjacent layer of the second, opposite conductivity type under which the said region of the first conductivity type is situated.

3. A charge-coupled device as claimed in Claim 2, characterized in that the layer of the second conductivity type has a thickness and a doping concentration at which the layer can be depleted throughout its entire thickness during operation without breakdown.

4. A charge-coupled device as claimed in any one of the preceding Claims, characterized in that electrodes are provided on the surface for controlling the storage and transport of charge in the charge transport channels, which electrodes comprise a charge transfer part ad a charge storage part.

5. A charge-coupled device as claimed in Claim 4, characterized in that the device comprises a system of at least two parallel channels situated next to one another with, seen in the charge transport direction, a first electrode which is common to both charge transport channels and which is followed by two separate electrodes for the two channels which are controlled so as to be in phase opposition.

6. A charge-coupled device as claimed in Claim 5, characterized in that the first electrode is controlled with a clock frequency which is twice the clock frequency with which the said separate electrodes are controlled.
